Europäisches Patentamt

European Patent Office

Office européen des brevets

(19)

(11) Veröffentlichungsnummer: **0 376 368 B1**

# EUROPÄISCHE PATENTSCHRIFT

(12)

(45) Veröffentlichungstag der Patentschrift: 26.04.95

(21) Anmeldenummer: 89203121.2

(22) Anmeldetag: 08.12.89

(51) Int. Cl.⁶: **C23C 14/16**, C23C 14/58, F16C 33/14, C21D 9/40, C22F 1/00

(54) **Verfahren zur Herstellung von Lagerungen.**

(30) Priorität: 24.12.88 DE 3843927

(43) Veröffentlichungstag der Anmeldung:
04.07.90 Patentblatt 90/27

(45) Bekanntmachung des Hinweises auf die Patenterteilung:
26.04.95 Patentblatt 95/17

(84) Benannte Vertragsstaaten:
AT DE ES FR GB IT

(56) Entgegenhaltungen:
EP-A- 0 265 937
EP-A- 0 272 447
DE-A- 2 043 676
FR-A- 2 443 926

PATENT ABSTRACTS OF JAPAN, vol. 12, no. 434 (M-764)[3281], 16. November 1988; & JP-A-63 167 122

(73) Patentinhaber: **KOLBENSCHMIDT Aktiengesellschaft**
**Karl-Schmidt-Strasse 8/12**
**Postfach 1351**
**D-74150 Neckarsulm (DE)**

(72) Erfinder: **Braus, Jürgen**
**Johann-Jakob-Astor-Strasse 53**
**D-6909 Walldorf (DE)**
Erfinder: **Matucha, Karl-Heinz, Dr.**
**Achimweg 2**
**D-6233 Kelkheim (DE)**
Erfinder: **Pfestorf, Harald**
**Panoramastrasse 18/1**
**D-7101 Untereisesheim (DE)**

(74) Vertreter: **Rieger, Harald, Dr.**
**Reuterweg 14**
**D-60323 Frankturt (DE)**

**Beschreibung**

Die Erfindung betrifft ein Verfahren zur Herstellung von Lagerungen aus wenigstens einer durch Kathodenzerstäubung auf einen metallischen Tragkörper aufgebrachten Lagermetallschicht, bestehend aus einer Grundmasse mit darin in statistischer Normalverteilung eingelagerten Teilchen aus metallischem Gleitwerkstoff mit einem mittleren Durchmesser von $\bar{x} < 0,8$ $\mu$m, vorzugsweise 0,05 bis 0,4 $\mu$m und eingelagertem Sauerstoff mit einem Gehalt von 0,005 bis 1,0 Masse-%.

Als Folge der Entwicklung im Brennkraftmaschinenbau zu immer größerer Leistungsdichte bei möglichst hoher Wirtschaftlichkeit im Hinblick auf einen möglichst niedrigen Kraftstoffverbrauch und wirtschaftliche Fertigung sind u.a. auch die Anforderungen an die Lagerungen von Kurbelwellen und Pleuel, insbesondere im Hinblick auf höhere Festigkeiten gegenüber dynamischen Wechselbeanspruchungen im Gebiet der Flüssigkeitsreibung sowie an das Gleitverhalten im Gebiet der Mischreibung gestiegen. Für den Hersteller besteht somit die Aufgabe, Lagerungen zu entwickeln, die den bei modernen Brennkraftmaschinen durch gesteigerte Zünddrücke, höhere Verdichtung und Turboaufladung auftretenden Beanspruchungen hinsichtlich Verringerung der Reibungsverluste, der Verschleißfestigkeit und Freßunempfindlichkeit weitgehend angepaßt sind.

Für diesen Zweck ist in der DE-C- 2 853 724 ein Werkstoffverbund vorgesehen, bei dem auf eine Trägerschicht durch Kathodenzerstäubung eine metallische Gleit- bzw. Reibschicht aufgebracht ist, in der härtere dispersionsverfestigend wirkende Teilchen in wesentlich unter 1,0 Gew.-% liegender Menge eingelagert sind, wobei die härteren Teilchen aus Oxiden von in dem Metall enthaltenen Bestandteilen bestehen und aus Oxiden solcher Metalle gebildet sind, bei denen das Metalloxid ein größeres Volumen als das Metall selbst aufweist. Das Ziel der Dispersionsverfestigung ist, die Beweglichkeit von Gitterbaufehlern, z. B. Versetzungen und Korngrenzen, durch die in feindisperser Verteilung vorliegenden Oxide so zu behindern, daß auch bei erhöhter Temperatur die Festigkeit und die Warmverschleißfestigkeit erhöht werden. Die für die Bildung der Oxide erforderliche Sauerstoffmenge ist entweder bereits in den durch normalen Strangguß hergestellten Targets enthalten oder wird während der Kathodenzerstäubung in das Plasmagas eingeleitet.

Da mit zunehmenden Mengen dispersionshärtender Oxide die Duktilität der Gleit- bzw. Reibschicht abnimmt und insbesondere das Notlauf- und Einlaufverhalten verschlechtert werden, kann das an sich erwünschte Potential der Dispersionshärtung zur Erzielung einer hohen Warmfestigkeit für Lagerungen nicht ausgeschöpft werden.

Diesem Nachteil wird durch die in der DE-A- 3 640 767 beschriebenen Lagerung begegnet, die aus wenigstens einer durch Kathodenzerstäubung auf einen metallischen Tragkörper aufgebrachten Lagermetallschicht aus einer Grundmasse mit darin statistischer Normalverteilung eingelagerten Teilchen aus metallischem Gleitwerkstoff mit einem mittleren Durchmesser von $\bar{x} < 0,8$ $\mu$m, vorzugsweise 0,05 bis 0,4 $\mu$m, und darin eingelagertem Sauerstoff mit einem Gehalt von 0,005 bis 1,0 Masse-% besteht. Die Lagermetallschichten solcher Lagerungen besitzen relativ große Mikrohärten im Bereich von 94 bis 120 (HV 0,002) und sind daher für bestimmte Anwendungsfälle, bei denen beispielsweise hohe Anforderungen an die Einbettfähigkeit und Notlaufeigenschaften bestehen, wegen mangelnder Verträglichkeit mit dem Gleitpartner, also Anpassungsfähigkeit, Einlauffähigkeit und Freßunempfindlichkeit, nicht einsetzbar.

Es ist die Aufgabe der vorliegenden Erfindung, die Mikrohärte der Lagermetallschichten der eingangs beschriebenen Lagerungen innerhalb eines vergleichsweise weiten Bereichs, dessen untere Grenze bis zu 50 % der Ausgangsmikrohärte betragen kann, gezielt auf bestimmte Werte zu senken, um damit die Lagerungen den jeweils mechanisch-technologischen Anforderungen der Gleitpartner, insbesondere hinsichtlich Einbettfähigkeit, Notlaufeigenschaften, Verschleißfähigkeit und Freßunempfindlichkeit anpassen zu können.

Die Lösung dieser Aufgabe erfolgt in der Weise, daß die Lagerungen einer isothermen Wärmebehandlung an Luft bei Temperaturen von 170 bis 230 °C mit der Maßgabe unterworfen werden, daß mit steigender Temperatur die Mikrohärte der Lagermetallschicht abnimmt.

Die Ausgestaltung des anmeldungsgemäßen Verfahrens ist darin zu sehen, daß der vorzugsweise in Betracht kommende Temperaturbereich für die isotherme Wärmeauslagerung 190 bis 220 °C beträgt und nach einem weiteren Merkmal der Erfindung die Dauer der isothermen Wärmebehandlung mit maximal 5 Stunden für die Erzielung des gewünschten Erfolgs ausreichend ist.

Die mit dem erfindungsgemäß durchgeführten Verfahren erzielte Wirkung ist anhand der Zeichnungen, die nachfolgend näher erläutert sind, beispielhaft dargestellt.

Die Zeichnungen zeigen die Änderung der Ausgangsmikrohärte der Lagermetallschichten, deren genaue Zusammensetzung in nachstehender Tabelle wiedergegeben ist, der Lagerungen A, B und C in Abhängigkeit von der Glühtemperatur bei 1-, 5- und 10-stündiger Glühdauer (Figen. 1, 2 und 3). Die Lagermetallschicht der Lagerung A besitzt einen vergleichsweise hohen Sauerstoffgehalt, diejenige der Lagerungen B und C einen vergleichsweise niedrigen Sauerstoffgehalt. Die Lagermetallschicht der Lagerung D weist eine Zusammensetzung auf, wie diese in der DE-C-2 853 724 angegeben ist. Die isotherme Wärmebehandlung wurde an Luft bei 170°C, 180°C, 190°C, 200°C, 210°C, 225°C und 325°C durchgeführt. Neben den Ausgangsmikrohärten wurden die Mikrohärten der Lagermetallschichten nach 1-, 5- und 10-stündiger Wärmebehandlung aus je fünf Einzelmessungen ermittelt.

Die gemessenen isothermen Mikrohärten zeigen, daß bei allen Wärmebehandlungstemperaturen die Mikrohärte abnimmt und um so größer ist, je höher die Wärmebehandlungstemperatur ist. Für Temperaturen größer 200°C erfolgt zu Beginn der Wärmebehandlung eine größere Abnahme der Mikrohärte, die danach zeitlich gering ist. Die Abnahme der Mikrohärte für die Lagermetallschicht der Lagerung D ist vergleichsweise unbedeutend.

Der mit der Erfindung erzielte Vorteil besteht darin, daß sich die Mikrohärten der Lagermetallschichten mit vergleichsweise geringem Sauerstoffgehalt durch eine Wärmebehandlung im Temperaturbereich insbesondere von 190 bis 210°C in einem weiten Bereich variieren und sich damit problemlos den gewünschten, den Anforderungen entsprechenden Werten einstellen lassen. Die gewünschte Mikrohärte der Lagermetallschichten hängt dabei vor allem von der Höhe der Wärmebehandlungstemperatur und weniger von der Dauer der Wärmebehandlung ab, da die maßgebliche Änderung der Mikrohärte innerhalb der ersten 5 Stunden der Wärmebehandlung erfolgt.

| Masse-% / Lagerung | Al | Sn | Cu | Ni | Pb | O |
|---|---|---|---|---|---|---|
| B | 83,1 | 16,6 | 1,3 | 0,37 | - | 0,01 |
| C | 84,1 | 16,4 | 1,3 | 0,41 | 0,13 | 0,02 |
| A | 83,7 | 14,9 | 1,3 | 0,45 | 0,10 | 1,89 |

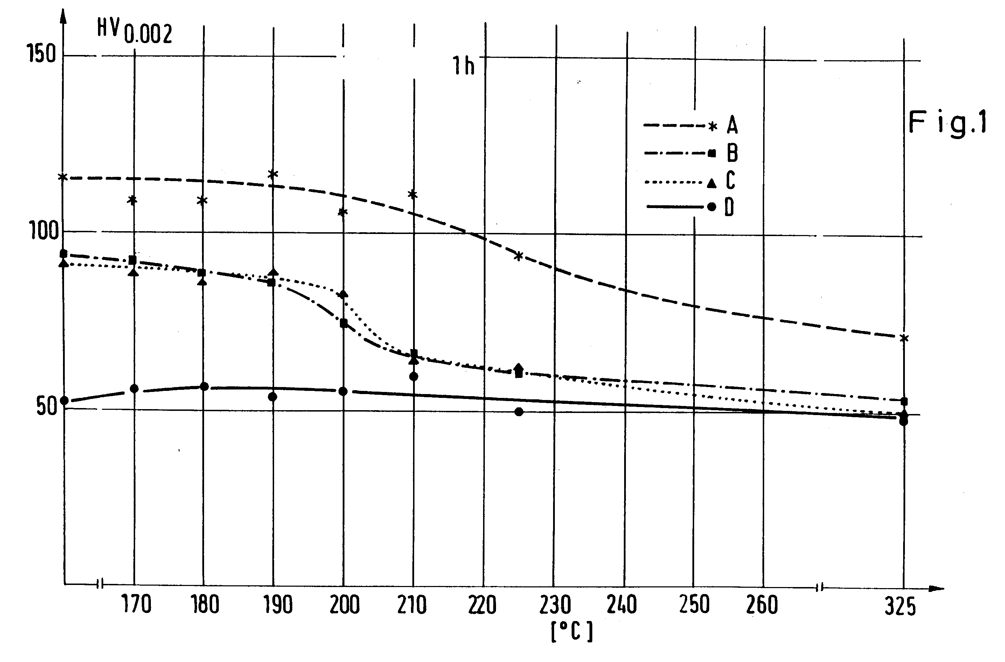

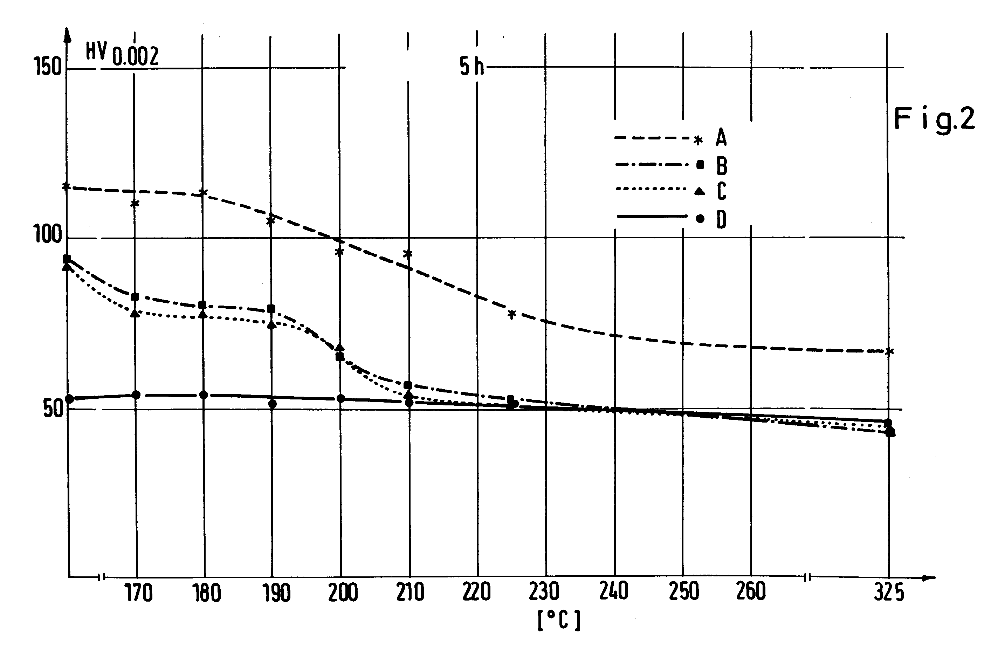

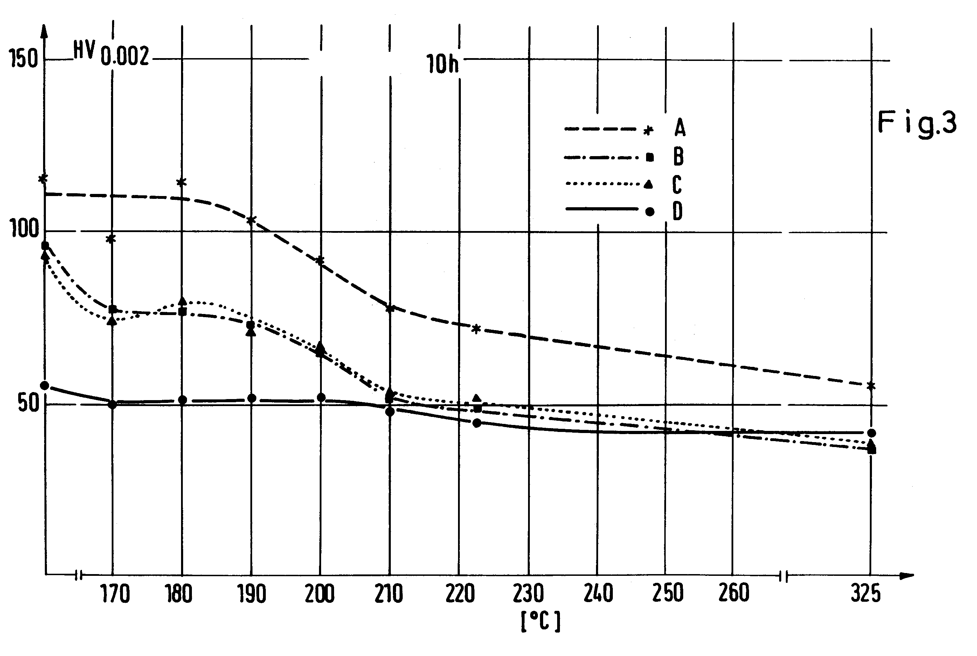

**Patentansprüche**

1. Verfahren zur Herstellung von Lagerungen aus wenigstens einer durch Kathodenzerstäubung auf einen metallischen Tragkörper aufgebrachten Lagermetallschicht, bestehend aus einer Grundmasse mit darin in statistischer Normalverteilung eingelagerten Teilchen aus metallischem Gleitwerkstoff mit einem mittleren Durchmesser von $\bar{x}$ < 0,8 $\mu$m, vorzugsweise 0,05 bis 0,4 $\mu$m und darin eingelagertem Sauerstoff mit einem Gehalt von 0,005 bis 1,0 Masse-%, dadurch gekennzeichnet, daß die Lagerungen einer isothermen Wärmebehandlung an Luft im Temperaturbereich von 170 bis 230°C mit der Maßgabe unterworfen werden, daß mit steigenden Temperaturen die Mikrohärte der Lagermetallschicht abnimmt.

2. Verfahren nach Anspruch 1, dadurch gekennzeichnet, daß die Lagerungen einer isothermen Wärmebehandlung an Luft bei Temperaturen von 190 bis 220°C unterworfen werden.

3. Verfahren nach den Ansprüchen 1 und 2, dadurch gekennzeichnet, daß die Dauer der isothermen Wärmebehandlung 0,5 bis 5 Stunden beträgt.

4. Verfahren nach den Ansprüchen 1 bis 3, dadurch gekennzeichnet, daß die Grundmasse der Lagermetallschicht aus einem Lagermetall auf der Basis von Aluminium, Kupfer oder Eisen besteht.

5. Verfahren nach den Ansprüchen 1 bis 4, dadurch gekennzeichnet, daß die in der Grundmasse eingelagerten Teilchen aus Zinn, Blei, Wismut, Kupfer und/oder Zink bestehen.

6. Verfahren nach den Ansprüchen 1 bis 5, dadurch gekennzeichnet, daß die Lagermetallschicht aus einer Legierung des Typs AlSn5Cu, AlSn10Cu, AlSn20Cu, AlSn30Cu, AlSn40Cu, AlSn10Pb10Cu oder AlZn5Pb besteht.

**Claims**

1. A process of manufacturing bearing means comprising at least one bearing metal layer which has been applied by cathode sputtering to a metallic backing and consists of a matrix and of particles made of a low-friction metallic material and embedded in said matrix in a normal random distribution and having a median diameter $\bar{x}$ 0.8 $\mu$m, preferably 0.05 to 0.4 $\mu$m, and of included oxygen in an amount of 0.005 to 1.0% by mass characterized in that the bearing means are subjected in air to an isothermal heat treatment at temperatures in the range from 170 to 230°C to increasingly decrease the microhardness of the bearing metal layer as the temperature is increased.

2. A process according to claim 1, characterized in that the bearing means are subjected in the air to an isothermal heat treatment at temperatures from 190 to 220°C.

3. A process according to claims 1 and 2, characterized in that the isothermal heat treatment is performed for 0.5 to 5 hours.

4. A process according to claims 1 to 3, characterized in that the matrix of the bearing metal layer consists of a bearing metal on the basis of aluminum, copper or iron.

5. A process according to claims 1 to 4, characterized in that the particles embedded in the matrix consist of tin, lead, bismuth, copper and/or zinc.

6. A process according to claims 1 to 5, characterized in that the bearing metal layer consists of an alloy of the type AlSn5Cu, AlSn10Cu, AlSn20Cu, AlSn30Cu, AlSn40Cu, AlSn10PbCu or AlZnSPb.

**Revendications**

1. Procédé de fabrication de paliers en au moins une couche de métal antifriction, déposée par pulvérisation cathodique sur un support métallique et constituée d'une masse de base ayant en son sein des particules en matériau métallique de glissement incorporées suivant une répartition statistique normale, et d'un diamètre $\bar{x}$ < 0,8 $\mu$m et, de préférence, de 0,05 à 0,4 $\mu$m et de l'oxygène incorporé en une teneur de 0,005 à 1,0% en poids, caractérisé en ce qu'il consiste à soumettre les paliers à un traitement isotherme à l'air dans un intervalle de température de 170 à 230°C en sorte que la microdureté de la couche de métal antifriction diminue lorsque les températures s'élèvent.

2. Procédé suivant la revendication 1, caractérisé en ce qu'il consiste à soumettre les paliers à un traitement thermique isotherme à l'air à des températures 190 à 290°C.

3. Procédé suivant les revendications 1 et 2, caractérisé en ce que la durée du traitement thermique isotherme est de 0,5 à 5 heures.

4. Procédé suivant l'une des revendications 1 à 3, caractérisé en ce que la masse de base de la couche de métal antifriction est en un métal antifriction à base d'aluminium, de cuivre ou de fer.

5. Procédé suivant l'une des revendications 1 à 4, caractérisé en ce que les particules incorporées à la masse de base sont en étain, plomb, bismuth, cuivre et/ou zinc.

6. Procédé suivant l'une des revendications 1 à 5, caractérisé en ce que la couche de métal antifriction est en un alliage du type AlSn5Cu, AlSn10Cu, ,AlSn20Cu, AlSn30Cu, AlSn40Cu, AlSn10Pb10Cu, ou AlZn5Pb.

Fig.1

EP 0 376 368 B1

Fig.2

Fig.3

EP 0 376 368 B1